# EUROPEAN PATENT APPLICATION

(11) **EP 4 618 705 A1**
(43) Date of publication of application: **17.09.2025**
(21) Application number: 25162621.4
(22) Date of filing: 10.03.2025
(51) Int. Cl.: H05K 7/20, G06F 1/20

(54) **POWER SUPPLY**

(30) Priority: 13.03.2024 TW 113202528 U
(71) Applicant: Cooler Master Technology Inc., Tapei City 114065 (TW)
(72) Inventor: CHIA-WEI, LIN, 114065 Taipei City (TW); YEN-CHUAN, CHEN, 114065 Taipei City (TW)
(74) Representative: Grünecker Patent- und Rechtsanwälte PartG mbB

(57) **Abstract**

A power supply having a circuit board, a heat dissipation housing, and a plurality of heat-generating assemblies. Each of the heat-generating assemblies includes a thermal conductive core that is thermally in contact with the heat dissipation housing, and a magnetic coil that is disposed on the thermal conductive core and electrically connected to the circuit board, wherein the magnetic coils of the heat-generating assemblies are coaxially arranged and connected in series through the circuit board.

## Description

### TECHNICAL FIELD

The present disclosure is related to the field of power supply, in particular to a power supply have multiple magnetic coils.

### BACKGROUND

Generally speaking, a computer consists of a chassis, power supply, motherboard, CPU, graphics card, and expansion card. The power supply and motherboard are installed in the chassis, and the power supply can convert the external AC power into DC power and provide DC voltage to the motherboard.

When a power supply delivers DC voltage to the motherboard, a large amount of heat is generated. Manufacturers often install heat dissipation components to dissipate heat from power supplies. However, the current power supply is still not accurate enough to manage the inductance, therefore the power supply's current output is unsteady. As a result, the heat dissipation efficiency of the power supply will be decreased, which in turn will reduce the service life of the power supply. Therefore, researchers in this field are committed to addressing the challenge of enhancing the heat dissipation efficiency of the power supply in order to extend its service life.

### SUMMARY

The invention is as as defined in the appended claims. Aspects of the disclosure provide a power supply. The power supply includes a circuit board, a heat dissipation housing, and a plurality of heat-generating assemblies. Each of the heat-generating assemblies includes a thermal conductive core that is thermally in contact with the heat dissipation housing, and a magnetic coil that is disposed on the thermal conductive core and electrically connected to the circuit board, wherein the magnetic coils of the heat-generating assemblies are coaxially arranged and connected in series through the circuit board.

In an embodiment, the thermal conductive cores and the magnetic coils are disposed in the heat dissipation housing.

In an embodiment, the heat dissipation housing further includes a base plate, a plurality of side plates and a top plate, the side plates are connected to each other, and the bottom plate and the top plate are respectively connected to the opposite two sides of the side plates.

In an embodiment, each of the side plates includes a first base and a first fin portion, the first fin portion is disposed on the first base, and the top plate includes a second base and a second fin portion, the second fin portion is disposed on the second base portion.

In an embodiment, the power supply can further include a plurality of first fasteners, a plurality of second fasteners and a plurality of third fasteners, the side plates are connected to each other by the first fasteners, the side plates are fixed to the bottom plate by the second fasteners, and the top plate is fixed to the side plates by the third fasteners.

In an embodiment, each of the thermal conductive cores includes a first thermal conductive portion, a second thermal conductive portion, a first cylinder and a second cylinder, the first thermal conductive portion is connected with the second thermal conductive portion, the first cylinder is arranged in the first thermal conductive portion, the second cylinder is arranged in the second thermal conductive portion, the first cylinder is connected with the second cylinder, and each of the magnetic coils is disposed around the first cylinder and the second cylinder, and is located between the first thermal conductive portion and the second thermal conductive portion.

In an embodiment, each of the first thermal conductive portion has a thickness that is different from a thickness of each of the second thermal conductive portion. In an embodiment, the magnetic coils are made of flat copper wires. In an embodiment, each coil of the magnetic coils has a thickness of 0.3 mm and a width of 6 mm. In an embodiment, each of the magnetic coils has 47 turns.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a perspective view of a power supply 10 according to aspects of the present disclosure.
Fig. 2 illustrates a perspective view of the power supply 10 as shown in Fig. 1.
Fig. 3 illustrates an exploded view of the power supply 10 as shown in Fig. 1.
Fig. 4 illustrates an exploded view of the heat-generating assemblies 13 as shown in Fig. 3.
Fig. 5 illustrates a cross-section view of the power supply 10 along the AA cutline as shown in Fig. 2.
Fig. 6 illustrates a cross-section view of the heat-generating assemblies 13 along the BB cutline as shown in Fig. 3.
Fig. 7 illustrates a front view of a magnetic coil 132 of the power supply 10 as shown in Fig. 3.
Fig. 8 illustrates a side view of the magnetic coil 132 of the power supply 10 as shown in Fig. 3.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

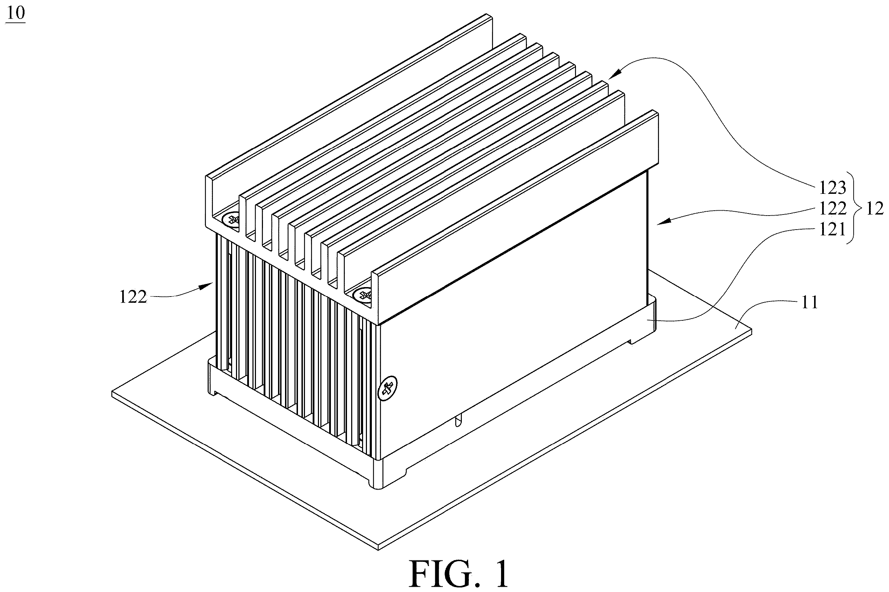

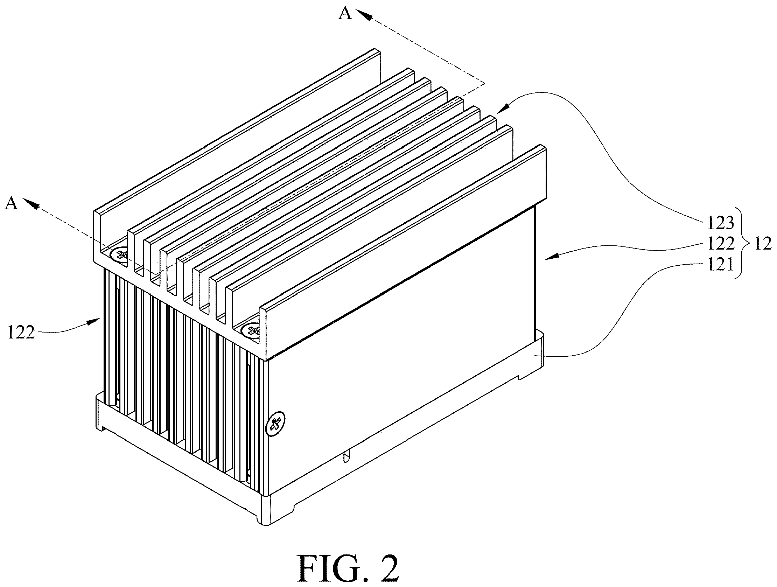

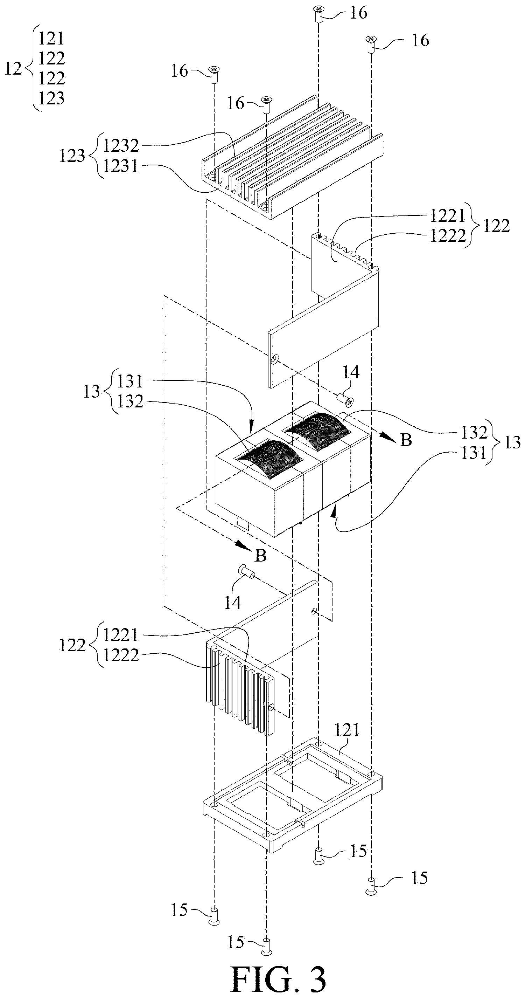

Referring to Figs. 1 to 3. Fig. 1 illustrates a perspective view of a power supply 10 according to aspects of the present disclosure. Fig. 2 illustrates a perspective view of the power supply 10 as shown in Fig. 1. Fig. 3 illustrates an exploded view of the power supply 10 as shown in Fig. 1.

The power supply 10 includes a circuit board 11, a heat dissipation housing 12 and a plurality of heat-generating assemblies 13. The circuit board 11 can contain, for example, electronic components such as capacitors, inductors, and transformers (not shown), but is not limited to this.

The heat dissipation housing 12 can connect to an external fan (not shown) to dissipate heat. The heat dissipation housing 12 can include a base plate 121, a plurality of side plates 122 and a top plate 123. The side plates 122 are connected to each other, and the bottom plate 121 and the top plate 123 are respectively connected to opposite two sides of the side plates 122 to form a space within. Each of the side plates 122 includes a base 1221 and a plurality of fins 1222. The fins 1222 is disposed on the base 1221. In the embodiment shown in Fig. 3, only two side plates 122 are used each having an L-shape, whereby the fins 1222 are only disposed on the shorter leg of the base 1221. The top plate 123 includes a base 1231 and a plurality of fins 1232. The fins 1232 are disposed on the base 1231. The heat dissipation shell 12 can be made of aluminum alloy for example, and the fins 1222 and 1232 can be made of aluminum extrusion. The fins 1222 and 1232 can improve the heat dissipation efficiency of the power supply 10.

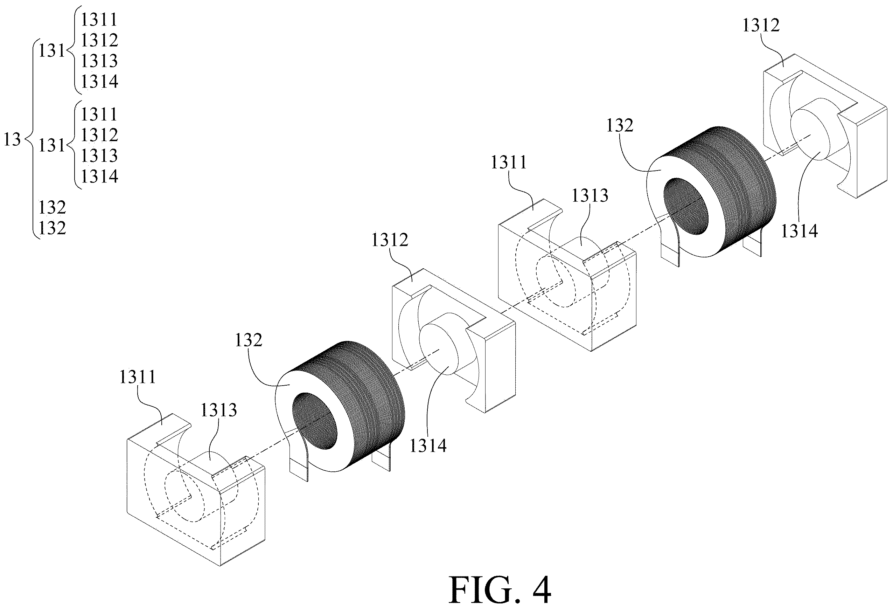

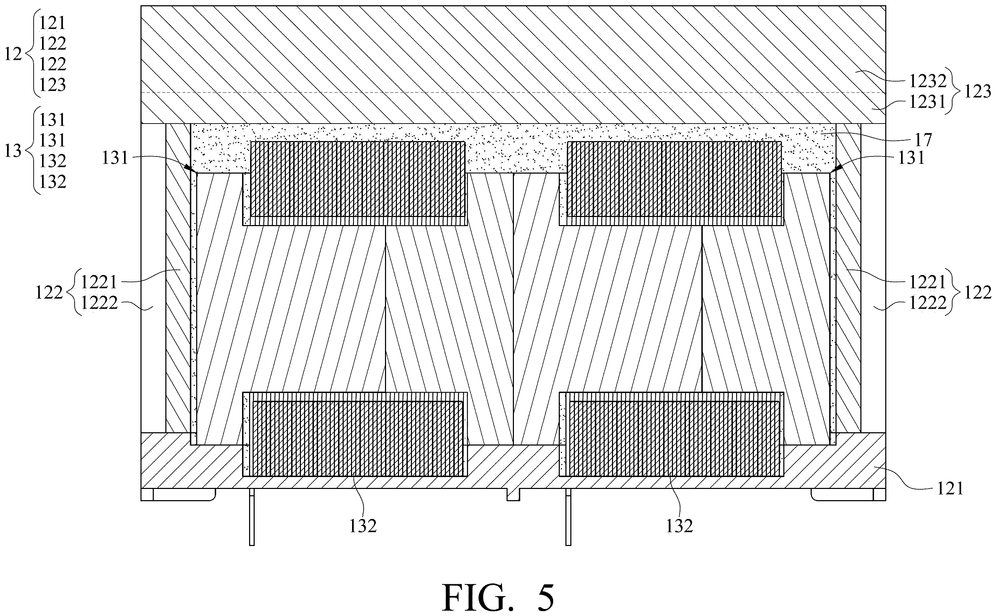

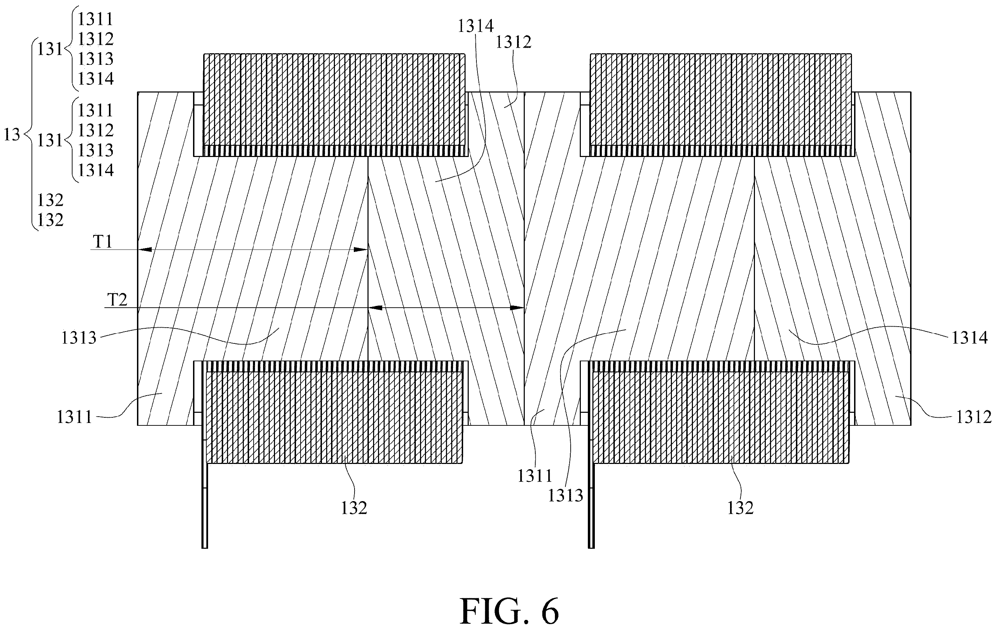

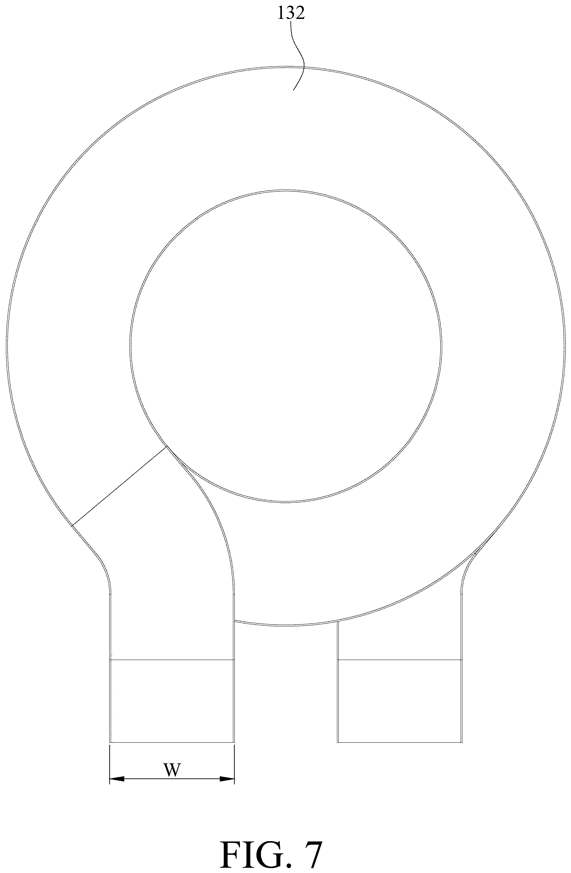

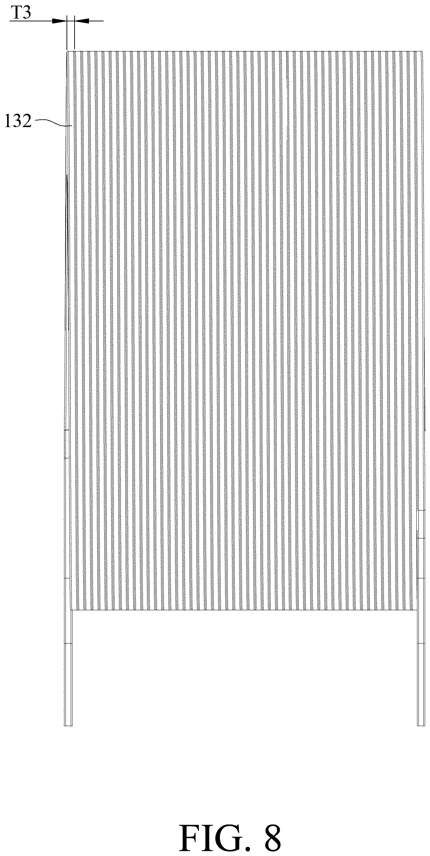

Please also refer to Figs. 4 to 8. Fig. 4 illustrates an exploded view of the heat-generating assemblies 13 as shown in Fig. 3. Fig. 5 illustrates a cross-section view of the power supply 10 along the AA cutline as shown in Fig. 2. Fig. 6 illustrates a cross-section view of the heat-generating assemblies 13 along the BB cutline as shown in Fig. 3. Fig. 7 illustrates a front view of a magnetic coil 132 of the power supply 10 as shown in Fig. 3. Fig. 8 illustrates a side view of the magnetic coil 132 of the power supply 10 as shown in Fig. 3.

The heat-generating assemblies 13 can have the function of a power factor correction (PFC) circuit. The PFC circuit serves to enhancing the power utilization rate by correcting the power factor of the circuit. The closer the power factor is to 1, the higher the efficiency of electricity utilization.

Each of the heat-generating assemblies 13, comprising a thermal conductive core 131 and a magnetic coil 132, is used to supply power to the circuit board 11. The thermal conductive cores 131 and the magnetic coils 132 are disposed in the heat dissipation housing 12. The thermal conductive cores 131 thermally contact the heat dissipation housing 12. Each of the thermal conductive cores 131 includes a first thermal conductive portion 1311, a second thermal conductive portion 1312, a first cylinder 1313 and a second cylinder 1314. The first thermal conductive portion 1311 is connected with the second thermal conductive portion 1312. The first cylinder 1313 is disposed in the first thermal conductive portion 1311. The second cylinder 1314 is disposed in the second thermal conductive section 1312. The first cylinder 1313 connects to the second cylinder 1314. The first thermal conductive portion 1311 has a thickness T1 that can be different from the thickness T2 of the second thermal conductive portion 1312 (preferably the T1/T2 ratio is in the range of more than 1 and less than 2, preferably between 1.25 and 1.75, and most preferably approx. 1,5). In some embodiment, the thickness T1 and the thickness T2 can be the same.

The magnetic coil 132 is disposed around the first cylinder 1313 and the second cylinder 1314 of the thermal conductive core 131, and is at least partially enclosed between the first thermal conductive portion 1311 and the second thermal conductive portion 1312. The magnetic coils 132 are electrically connected to the circuit board 11 and are arranged coaxially. The magnetic coils 132 are connected in series through the circuit board 11. The magnetic coils 132 can be made of flat copper wires. In an embodiment, each coil of the magnetic coils 132 can have a thickness T3 equal to 0.3 mm and a width W equal to 6 mm. The number of coils in each of the magnetic coils 132 can be 47 to achieve the required inductance of the heat-generating assembly 13. In this way, the inductance of a single heat-generating assembly 13 can be about 350 µH. The inductance of a dual heat-generating assemblies 13 containing two magnetic coils 132 in series can be about 700 µH.

Since the magnetic coils 132 are connected in series, the power supply 10 can store more electrical energy and can distribute the current through the circuit board 11, and the accuracy of the power supply 10 in managing the inductance can be enhanced, and the current output of the power supply 10 can be more steady. In this way, the heat dissipation efficiency of the power supply 10 can be enhanced to extend its service life.

The flat copper wire of the magnetic coils 132 can mitigate the skin effect, so as to reduce copper loss and lower the temperature increase of the heat-generating assemblies 13 in heat dissipation housing 12. In this way, the external fans connected to the heat-generating assemblies 13 do not need run on extensive rotational speed to dissipate heat. This further enhance the heat dissipation efficiency of the power supply 10. The skin effect is a phenomenon in which the current inside the conductor is unevenly distributed when there is alternating current or alternating electromagnetic field in the conductor, so that the current in the conductor is concentrated on the surface of the conductor, and almost no current flows through the central part of the conductor. The skin effect causes the current to produce a thermal effect to the surface of the conductor, resulting in a high copper loss. In addition, copper loss can also be referred to as the loss of energy, as the heat generated by the flow of electric current through a conductor, for example, on a transformer or other electronic device.

As shown in Fig. 3, the power supply 10 may also include a plurality of fasteners 14, 15, and 16. The fasteners 14, 15, and 16 can, for example, be screws. The side plates 122 are connected to each other and fixed by the fasteners 14. The side plates 122 are fixed to the bottom plate 121 by the fasteners 15. The top plate 123 is fixed to the side plates 122 by the fasteners 16.

The power supply 10 may further include a thermal conductive fluid 17. The thermal conductive fluid 17 can be thermally conductive silica gel or wax, but not limited to this. Other thermal conductive fluid that is suitable for the specific application can also be used. In an embodiment, the thermal conductivity of the thermal conductive fluid 17 can be 2 W/m·K (Watt per meter per Kelvin). In an embodiment, the heat transfer fluid 17 can be a black liquid.

The thermal conductive fluid 17 can be filled in the heat dissipation housing 12. First, the top plate 123 can be fixed to the side plates 122 through the fasteners 16. At this moment, because the side plates 122 have not been fixed on the bottom plate 121, the bottom of the heat dissipation housing 12 has not been closed. Then, the thermal conductive fluid 17 can be injected into the heat dissipation housing 12 from the bottom of the heat dissipation housing 12. In an embodiment, the injection amount of the thermal conductive fluid 17 can be about 7 grams. Last, the side plates 122 having the top plates 123 fixed thereon are fixed to the bottom plate 121 through the fasteners 15 to close the bottom of the heat dissipation housing 12. By having a heat conductive fluid 17, the heat generated by the heat-generating assemblies 13 can be further transmitted to the heat dissipation housing 12, and the thermal conductive core 131 of the heat-generating assemblies 13 and the magnetic coils 132 can be further thermally balanced, so that the heat dissipation efficiency of the heat-generating assemblies 13 can be further enhanced.

In the above embodiments, the number of heat-generating assemblies 13 is plural, but is not limited to this. In some embodiments, the number of the heat-generating assembly can also be limited to one. In the above embodiments, the power supply 10 has the bottom plate 121, the side plates 122 and the top plate 123 fixed through the fasteners 14, 15, and 16, but is not limited thereto. In some embodiments, the power supply may have the base plate, the side plates, and the top plate fixed by other fixing methods.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A power supply (10), comprising:
a circuit board (11);
a heat dissipation housing (12); and
a plurality of heat-generating assemblies (13), each including:
a thermal conductive core (131) that is thermally in contact with the heat dissipation housing (12); and
a magnetic coil (132) that is disposed on the thermal conductive core (131) and electrically connected to the circuit board (11),
wherein the magnetic coils (132) of the heat-generating assemblies (13) are coaxially arranged and connected in series through the circuit board (11).

2. The power supply (10) of claim 1, wherein the thermal conductive cores (131) and the magnetic coils (132) are disposed in the heat dissipation housing (12).

3. The power supply (10) of claim 1 or 2, wherein the heat dissipation housing (12) further includes a base plate (121), a plurality of side plates (122) and a top plate (123), the side plates (122) are connected to each other, and the bottom plate (121) and the top plate (123) are respectively connected to the opposite two sides of the side plates (122).

4. The power supply (10) of claim 3, wherein each of the side plates (122) includes a first base (1221) and a first fin portion (1222), the first fin portion (1222) is disposed on the first base (1221), and the top plate (123) includes a second base (1231) and a second fin portion (1232), the second fin portion (1232) is disposed on the second base portion (1231).

5. The power supply (10) of claim 3 or 4, further comprises a plurality of first fasteners (14), a plurality of second fasteners (15) and a plurality of third fasteners (16), the side plates (122) are connected to each other by the first fasteners (14), the side plates (122) are fixed to the bottom plate (121) by the second fasteners (15), and the top plate (123) is fixed to the side plates (122) by the third fasteners (16).

6. The power supply (10) of one of claims 1 to 5, wherein each of the thermal conductive cores (131) includes a first thermal conductive portion (1311), a second thermal conductive portion (1312), a first cylinder (1313) and a second cylinder (1314), the first thermal conductive portion (1311) is connected with the second thermal conductive portion (1312), the first cylinder (1313) is arranged in the first thermal conductive portion (1311), the second cylinder (1314) is arranged in the second thermal conductive portion (1312), the first cylinder (1313) is connected with the second cylinder (1314), and each of the magnetic coils (132) is disposed around the first cylinder (1313) and the second cylinder (1314), and is located between the first thermal conductive portion (1311) and the second thermal conductive portion (1312).

7. The power supply (10) of claim 6, wherein each of the first thermal conductive portion (1311) has a thickness that is different from a thickness of each of the second thermal conductive portion (1312).

8. The power supply (10) of one of claims 1 to 7, wherein the magnetic coils (132) are made of flat copper wires.

9. The power supply (10) of one of claims 1 to 8, wherein each coil of the magnetic coils (132) has a thickness (T3) and a width (W), whereby the width/thickness ratio is at least 10, preferably at least 15 or at least 20, and whereby most preferably the thickness (T3) is 0.3 mm and the width (W) is 6 mm.

10. The power supply (10) of one of claims 1 to 9, wherein each of the magnetic coils (132) has more than 20 turns, preferably more than 35 turns, and less than 80 turns, preferably less than 60 turns, and most preferably 47 turns.
